# EUROPEAN PATENT APPLICATION

(11) **EP 4 451 326 A1**
(43) Date of publication of application: **23.10.2024**
(21) Application number: 22907423.2
(22) Date of filing: 12.12.2022
(51) Int. Cl.: H01L 23/473, H05K 7/20, H01M 10/613, H01M 10/653, H01M 10/6554, H01M 10/6556, H01M 10/6563, H01M 10/6568

(54) **COOLING STRUCTURE**

(30) Priority: 14.12.2021 JP 2021202702
(71) Applicant: Resonac Corporation, Tokyo 105-7325 (JP)
(72) Inventor: FUKUKAWA, YUJI, Tokyo 100-6606 (JP); YAMASHITA, Takahiro, Tagawa-shi, Fukuoka 825-0005 (JP); ITO, Seiichi, Tokyo 100-6606 (JP); SHODA, Hiroaki, Tagawa-shi, Fukuoka 825-0005 (JP)
(74) Representative: Berggren Oy
(86) International application number: PCT/JP2022/045723
(87) International publication number: WO 2023/112899

(57) **Abstract**

The cooling structure has a refrigerant inlet, a refrigerant outlet, and a flow path made of resin and connecting the refrigerant inlet and the refrigerant outlet, in which a portion of a face configuring the flow path is open.

## Description

### Technical field

The present disclosure relates to a cooling structure.

### Background Art

As a countermeasure against heat generation in battery modules installed in electronic devices such as smartphones and computers, electric vehicles, and hybrid vehicles, or the like, there is a known technology to incorporate water coolers and heat pipes or the like inside the devices. Furthermore, in power semiconductor modules made of silicon carbide or the like, measures using cooling plates, heat sinks or the like have been proposed as a countermeasure against heat generation.

For example, a vehicle mounted a motor, such as a hybrid vehicle or an electric vehicle, is equipped with a drive means for driving the motor. The driving means includes a power module including a plurality of power semiconductors such as IGBTs (Insulated Gate Bipolar Transistors), electronic components such as capacitors, bus bars that electrically connect these electronic components, and the like. When driving a motor, a large current may flow through a bus bar that connects electronic components such as power semiconductors and capacitors. In this case, since the driving means generates heat due to switching loss, resistance loss, or the like, it is desirable to cool the driving means efficiently. Furthermore, it is desirable to efficiently cool the heat generated from battery modules mounted on vehicles.

Examples of a cooling structure include a structure made of a highly thermally conductive metal, such as an inner core of aluminum cooling fins. However, since it is made of metal, it is heavy, and since it is disposed on the object to be cooled by fusing or the like, it requires a certain degree of thickness, making it difficult to reduce its thickness.

Therefore, from the viewpoint of weight reduction and the like, a cooling structure was proposed, in which the outer packaging material and the inner core material are made of a laminate material in which a metal heat transfer layer is laminated with a resin layer, and the refrigerant flows through a flow path separated by the inner core material (for example, see Patent Documents 1 and 2).

### Related Art Documents

### Patent Documents

Patent Document 1: Japanese Patent Application Laid-Open (JP-A) No. 2020-3132
Patent Document 2: JP-A No. 2021-096041

### SUMMARY OF INVENTION

The cooling structures described in Patent Documents 1, 2 or the like are lightweight because they are made of laminate materials, but they are produced through many steps, and there is a demand for a cooling structure that is easily to produced.

Furthermore, in the cooling structures disclosed in Patent Documents 1, 2 or the like, a laminate material is pleated to form a concave and convex portion, and the concave and convex portion is used as a flow path. Since the flow path is formed by pleating, the direction of the flow path is limited to one direction. Therefore, the arrangement positions of the refrigerant inlet and the refrigerant outlet are fixed at one end and the other end in the one direction, and the degree of freedom in the arrangement of the refrigerant inlet and the refrigerant outlet is low. When installing a cooling structure in a vehicle such as an automobile, it is important to make effective use of limited space, and a high degree of freedom in structural design is desired.

In view of such circumstances, the present disclosure aims to provide a cooling structure that can be easily produced and has a high degree of freedom in structural design.

### Solution to Problem

Means for solving the above problems include the following embodiments.
<1> A cooling structure including a refrigerant inlet, a refrigerant outlet, and a flow path made of resin and connecting the refrigerant inlet and the refrigerant outlet, in which a portion of a face configuring the flow path is open.
<2> The cooling structure according to <1>, including a plurality of flow paths, in which the plurality of flow paths have respective open faces that open in a same direction.
<3> The cooling structure according to <1> or <2>, further including a member disposed at an area where the flow path is opened, the member and the cooling structure being entirely made of an identical resin material.
<4> The cooling structure according to <1> or <2>, further including a thermally conductive material disposed at an area where the flow path is opened
<5> The cooling structure according to <4>, in which the thermally conductive material includes a metal layer and a resin layer.
<6> The cooling structure according to any one of <1> to <5>, in which the refrigerant inlet, the refrigerant outlet and the flow path are integrally molded with resin.
<7> The cooling structure according to any one of <1> to <6>, further including a mounting member.

### Advantageous Effects of Invention

According to the present disclosure, it is possible to provide a cooling structure that can be easily produced and has a high degree of freedom in structural design.

### BRIEF DESCRIPTION OF DRAWINGS

FIG. 1 is a schematic perspective view showing one embodiment of a cooling structure.
FIG. 2 is a schematic perspective view showing one embodiment of a cooling structure.
FIG. 3 is a schematic perspective view showing one embodiment of a cooling structure.
FIG. 4 is a schematic perspective view showing one embodiment of a cooling structure.
FIG. 5 is a schematic perspective view showing one embodiment of a cooling structure.
FIG. 6 is a schematic perspective view showing one embodiment of a cooling structure.
FIGS. 7A and 7B are schematic perspective views showing one embodiment of a cooling structure.
FIG. 8 is a schematic perspective view showing one embodiment of a cooling structure.
FIG. 9A is a schematic perspective view showing one embodiment of a cooling structure, and FIG. 9B is an exploded view thereof.
FIG. 10 is an exploded view of one embodiment of a cooling structure.
FIG. 11 is a diagram illustrating a flow of refrigerant in a cooling structure of FIG. 10.
FIG. 12 is a schematic perspective view showing one embodiment of a cooling structure.

### DESCRIPTION OF EMBODIMENTS

Hereinafter, embodiments in the present disclosure will be described in detail. It is to be noted, however, that the present disclosure is not limited to the following embodiments. In the embodiments described below, components thereof (including element steps and the like) are not essential, unless otherwise specified. The same applies to numerical values and ranges thereof, and the present disclosure is not limited thereto.

In a case in which the embodiments in the present disclosure are described with reference to the drawings, the configuration of the embodiments is not limited to the configuration shown in the drawings. Furthermore, the sizes of the members in each figure are conceptual, and the relative size relationships between the members are not limited thereto. Further, in each drawing, members having substantially the same function are given the same reference numerals in all drawings, and duplicated explanations will be omitted.

In the present disclosure, the term "layer" comprehends herein not only a case in which the layer is formed over the whole observed region where the layer is present, but also a case in which the layer is formed only on part of the region.

In the present disclosure, the term "laminate" refers to stacking layers, and two or more layers may be bonded, or two or more layers may be detachable.

A cooling structure in the present disclosure includes a refrigerant inlet, a refrigerant outlet, and a flow path made of resin and connecting the refrigerant inlet and the refrigerant outlet, in which a portion of a face configuring the flow path is open.

The resin-made flow path can be easily produced by conventionally known methods such as injection molding, cast molding, press molding, blow molding, insert molding, extrusion molding, transfer molding or the like. The cooling structure in the present disclosure allows the flow path configuration to be designed more freely than conventional flow path formed using laminate materials, and as a result, the degree of freedom in the arrangement positions of the refrigerant inlet and refrigerant outlet can be increased. In addition, the cooling structure in the present disclosure has a simpler structure than a water jacket that incorporates other functions in addition to the cooling function, and therefore, complex mold designs such as die slide injection molding can be avoided. Further, since the cooling structure in the present disclosure is functionally separated to specialize in cooling, it can be arbitrarily disposed at a location where cooling is required.

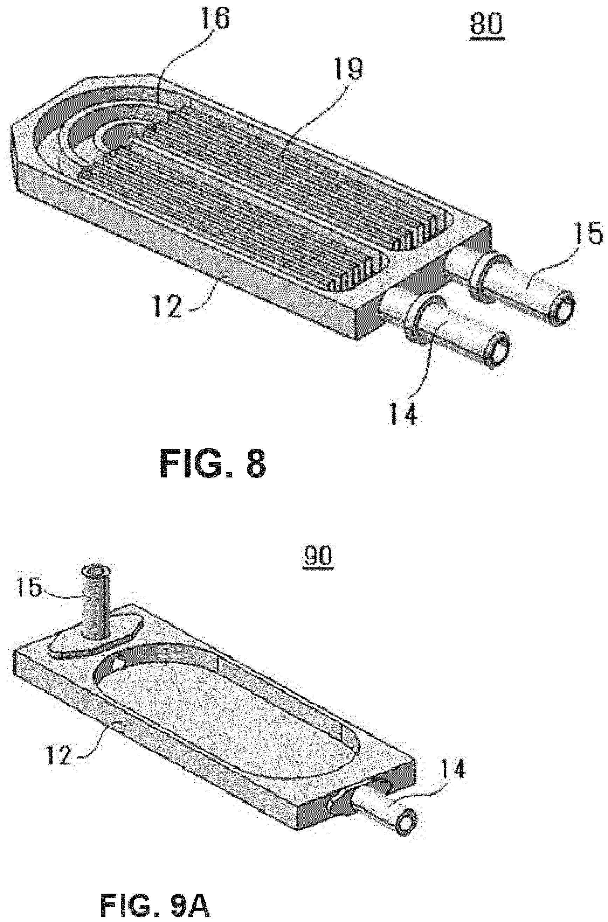

Further, in the cooling structure in the present disclosure, the directions of the refrigerant inlet and the refrigerant outlet can be freely designed. In the cooling structure of Patent Document 1, the refrigerant inlet and outlet are formed by sandwiching joint pipes between two laminate materials that serve as exterior materials, and thermally fusing thereof. However, it is difficult to thermally fuse the laminate material to the very edge of the joint pipe. Therefore, in FIG. 8 of Patent Document 2, a through hole is provided in one of the laminate members of the outer packaging material, and a joint pipe is passed through the through hole. In this case, the orientation of the refrigerant inlet and refrigerant outlet is limited to the thickness direction with respect to the cooling structure. As described above, in a cooling structure made of a laminate material, the directions of the refrigerant inlet and the refrigerant outlet are limited when trying to improve the sealing performance of the refrigerant at the refrigerant inlet and the refrigerant outlet. In contrast, in the cooling structure in the present disclosure, the directions of the refrigerant inlet and the refrigerant outlet can be freely designed, so that the limited space inside the vehicle can be effectively utilized.

In the cooling structure in the present disclosure, a portion of a face configuring the flow path is open, and a thermally conductive material may be provided in the open portion. An object to be cooled is cooled by disposing the cooling structure to the object to be cooled via the thermally conductive material. The area of the open portion may be adjusted depending on the required cooling capacity. For example, the cooling capacity can be increased by increasing the open portion so as to enlarge the portion where the thermally conductive material is disposed. On the other hand, in a case in which the open portion is made small and the non-open portion is made of resin or the like, the strength of the cooling structure increases and it becomes possible to use it at a location where a relatively large load is applied.

In the cooling structure in the present disclosure, a member may be arranged at the open portion, and the member and the cooling structure may be entirely made of polypropylene resin. Since the entire member and cooling structure are made of the same resin material, it is highly recyclable when discarded.

In a case in which there are plural flow paths in the cooling structure, it is preferable that the plural flow paths have respective open faces that open in a same direction. By being open in the same direction, only one piece of thermally conductive material is required to be disposed in the open portion. It is sufficient that at least one of the open faces in each flow path is a common face, and the cooling structure may have two open faces, such as both the bottom and top surfaces are open.

The type of refrigerant flowing through the flow path is not particularly limited. Examples of the refrigerant include liquids such as water and organic solvents, and gases such as air. The water used as a refrigerant may contain components such as antifreeze.

The cooling structure in the present disclosure can be widely used for cooling heating elements, for example, it is effective for cooling battery modules, power semiconductor modules or the like installed in electronic devices such as smartphones and personal computers, electric vehicles, hybrid vehicles or the like.

Hereinafter, the cooling structure in the present disclosure will be described with reference to the drawings. Note that the embodiments in the present disclosure are not limited to the embodiments shown in the drawings.

### <First Embodiment>

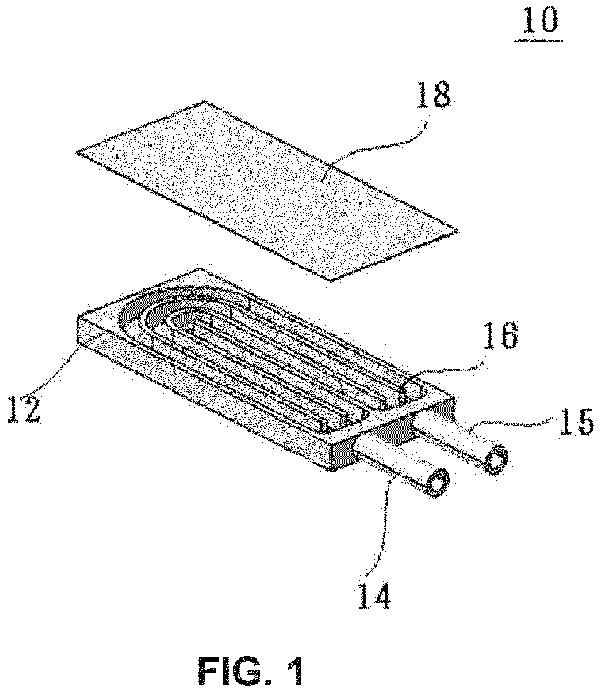

FIG. 1 is a schematic perspective view of a cooling structure 10 of one embodiment in the present disclosure. The cooling structure 10 shown in FIG. 1 has a refrigerant inlet 14 and a refrigerant outlet 15 in a casing 12, and has a flow path partitioned by a wall material 16 inside the casing 12. There may be only one flow path or a plurality of flow paths.

The wall material 16 is made of resin, and the casing 12 having a bottom face, the refrigerant inlet 14, and the refrigerant outlet 15 may also be made of resin. The casing 12, the refrigerant inlet 14, the refrigerant outlet 15, and the wall material 16 may be integrally molded with resin, or may be separated respectively and attached to the casing 12. From the viewpoint of simplifying the assembly process and reducing the number of parts, it is preferable that the casing 12, the refrigerant inlet 14, the refrigerant outlet 15, and the wall material 16 be integrated.

Examples of the resin include a polyethylene-based resin, a polypropylene-based resin (PP), a composite polypropylene-based resin (PPC), a polyphenylene sulfide-based resin (PPS), a polyphthalamide-based resin (PPA), a polybutylene terephthalate-based resin (PBT), an epoxy-based resin, a phenol-based resin, a polystyrene-based resin, a polyethylene terephthalate-based resin, a polyvinyl alcohol-based resin, a vinyl chloride-based resin, an ionomer-based resin, a polyamide-based resin, an acrylonitrile-butadiene-styrene copolymer resin (ABS), a polycarbonate-based resin.

The resin may include an inorganic filler. Examples of the inorganic filler include glass, silica, alumina, zircon, magnesium oxide, calcium silicate, calcium carbonate, potassium titanate, silicon carbide, silicon nitride, boron nitride, beryllia, and zirconia. Aluminum hydroxide, zinc borate or the like may be used as an inorganic filler having a flame retardant effect.

The wall material 16 of the cooling structure 10 is bent into a U shape and provided inside the casing 12. Therefore, the flow path is also U-shaped, and the refrigerant inlet 14 and the refrigerant outlet 15 are provided on the same side of the casing 12 along the direction of the flow path. The refrigerant inlet 14 and the refrigerant outlet 15 may be interchanged.

However, a shape, width, and length of the flow path are not particularly limited, and may be appropriately set depending on a size and shape of the object to be cooled, a required cooling capacity, or the like. The cross-sectional shape of the flow path in the width direction may be a rectangle, a circle, an ellipse, a polygon other than a rectangle, or the like. From the viewpoint of ease of manufacture, a rectangular shape is preferred. The wall material 16 forming the flow path may be flat or curved.

A size of the casing 12, a diameter and length of the refrigerant inlet 14 and the refrigerant outlet 15, and a thickness of the wall material 16 are not particularly limited, and may be appropriately set depending on the size and shape of the object to be cooled, a required cooling capacity, or the like.

The casing 12 has a bottom face and an open top face. A thermally conductive material 18 may be disposed at the open top face. By placing the thermally conductive material 18 at the open top face, the open top face of the flow path is closed.

The thermally conductive material 18 is not particularly limited as long as it has higher thermal conductivity than resin, and preferably includes at least one selected from the group consisting of a metal and an alloy, and preferably includes a metal. Examples of the metal include aluminum, iron, copper, gold, silver, and stainless.

The thermally conductive material 18 may be composed of a single layer or two or more layers. Examples of the single-layer thermally conductive material 18 include a metal foil, a metal plate, an alloy foil, and an alloy plate.

The thermally conductive material 18 composed of two or more layers may have a metal layer and a resin layer. Having a resin layer enables fusing to the cooling structure, an object to be cooled or the like. Examples of a resin that can be used in the resin layer include those mentioned above.

Examples of the thermally conductive material 18 composed of two or more layers include a two-layer structure in which a metal layer and a resin layer are laminated, and a three-layer structure in which a resin layer, a metal layer and a resin layer are laminated in this order.

A shape of the metal layer in the thermally conductive material 18 composed of two or more layers may be a foil, a plate, a sheet, a film or the like, and may be a mesh shape, punched metal or the like from the viewpoint of suppressing a load on the cooling structure 10 due to a difference in thermal expansion coefficient between the cooling structure 10 and the thermally conductive material 18.

The thermally conductive material 18 disposed on the open top face may be replaced with a resin member. From the viewpoint of recyclability, it is preferable that the resin member and the cooling structure are entirely made of an identical resin material. As such resin, those mentioned above may be applied, and the member and the cooling structure may be entirely made of polypropylene resin. The resin member disposed on the open top face is preferably a stretched polypropylene film because it has a high melting point and can be fused.

### <Second Embodiment>

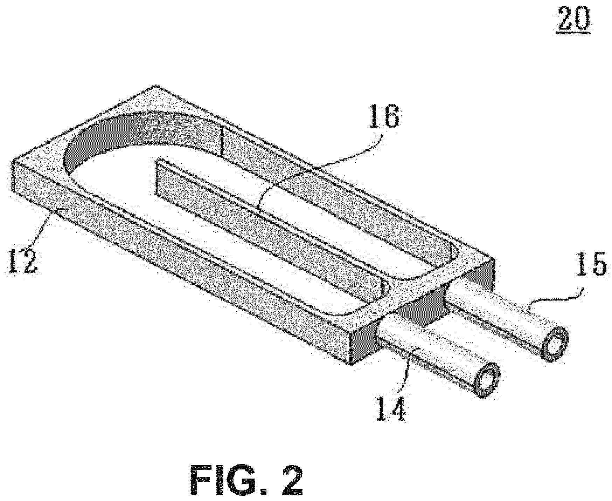

FIG. 2 is a schematic perspective view of a cooling structure 20 of another embodiment in the present disclosure. In the cooling structure 20 shown in FIG. 2, a casing 12 has an open bottom face and an open top face. In a case in which the cooling structure 20 has a wall material 16, it is preferable that the wall material 16 extends from the outer frame of the casing 12.

The thermally conductive material 18 or the above resin member may be disposed on at least one of the open bottom face and the open top face. The object to be cooled is cooled by disposing the cooling structure to the object to be cooled via the thermally conductive material 18 or the resin member.

### <Third embodiment>

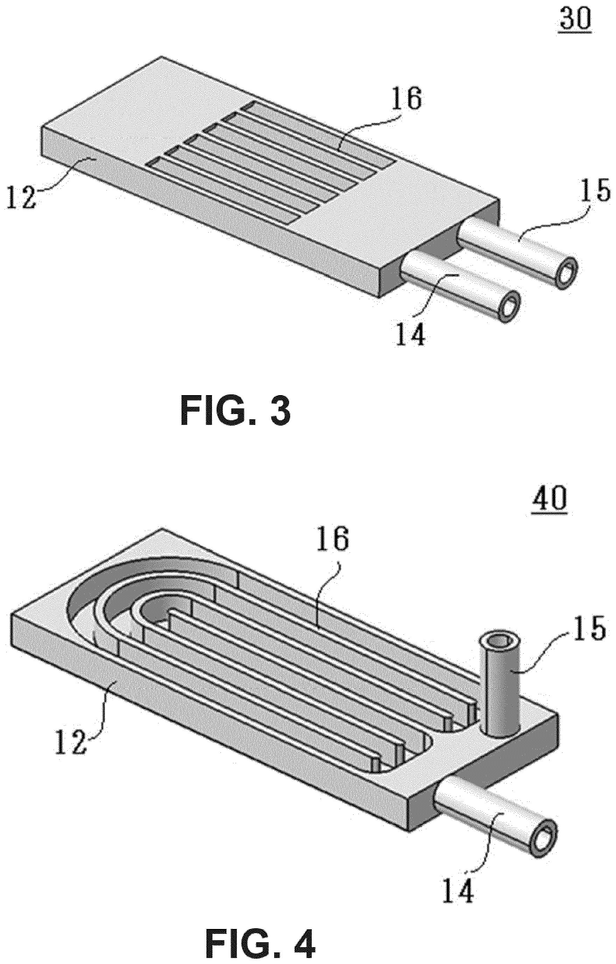

FIG. 3 is a schematic perspective view of a cooling structure 30 of another embodiment in the present disclosure. The cooling structure 30 shown in FIG. 3 differs from the cooling structure 10 in FIG. 1 in that not the entire top face of the casing 12 but a portion of the top face is open. That is, the casing 12 of the cooling structure 30 has a bottom face and a portion of the top face, and the other portion of the top face is open. The thermally conductive material 18 or the resin member may be disposed in the open portion of the top face.

Since the casing 12 has the portion of the top face, a strength against load received from the top face is improved, and the cooling structure 30 can be disposed even in a portion where a load is applied. A proportion of the portion where the top face is open can be appropriately designed depending on the applied load and required heat dissipation.

### <Fourth to Sixth Embodiments>

A cooling structures 40, 50, and 60 shown in FIGS. 4 to 6 are variations in which the directions of the refrigerant inlet 14 and the refrigerant outlet 15 are changed. The refrigerant inlet 14 and the refrigerant outlet 15 may be interchanged. Note that the casings 12 of the cooling structures 40, 50 and 60 have a bottom face and are open at the top, but the bottom face may also be open as shown in FIG. 2, or the top face may not be entirely open, but may be partially open as shown in FIG. 3.

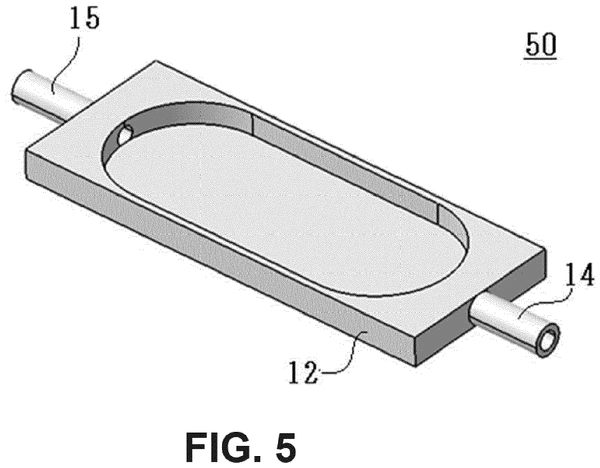

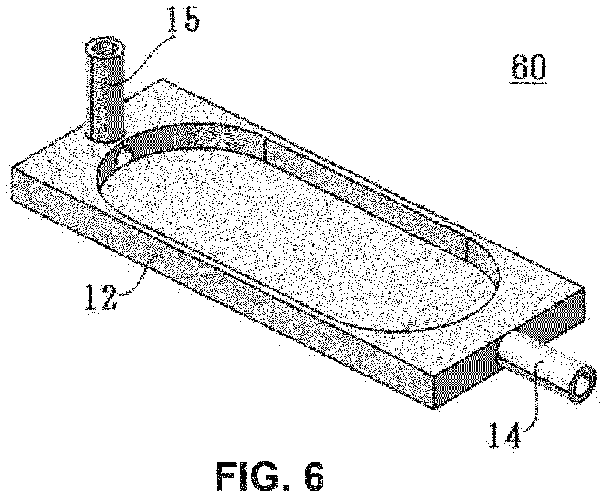

Unlike the cooling structures 50 and 60 shown in FIGS. 5 and 6, it may not have the wall material 16, and in which case the flow path is formed by the outer frame of the casing 12.

### <Seventh Embodiment>

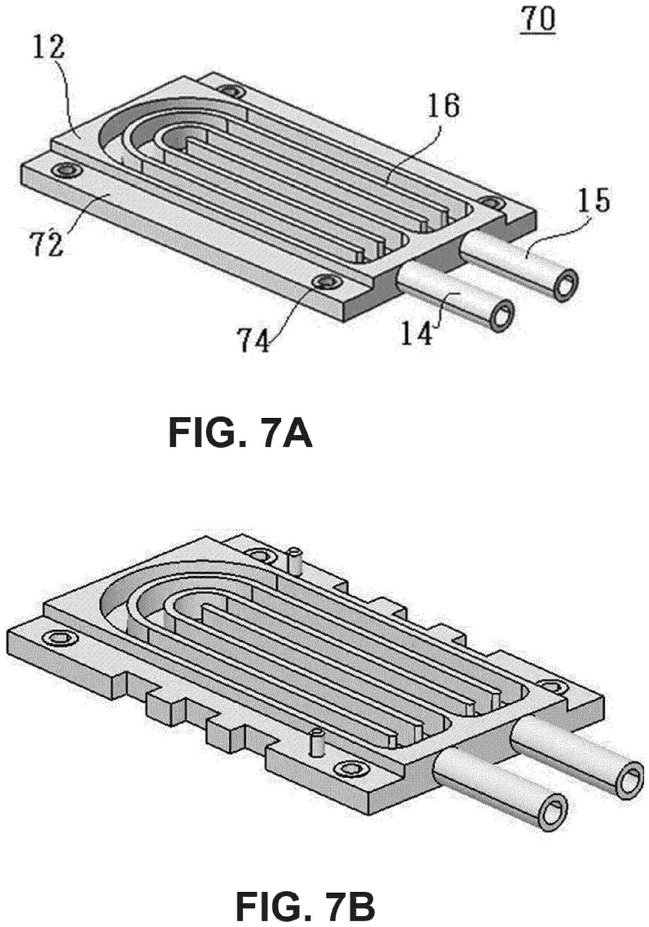

FIG. 7 is a schematic perspective view of a cooling structure 70 of another embodiment in the present disclosure. The cooling structure 70 shown in FIG. 7A includes a mounting member 72 on the casing 12. In FIG. 7A, a frame is provided as the mounting member 72 on both sides of the casing 12, and a bolt mounting hole 74 for mounting a bolt is bored in the frame. The frame may be made of the same resin as the casing 12, and may be integrally molded with the casing 12. The mounting member 72 is not particularly limited as long as it can be mounted to the object to be cooled, and examples other than the bolt attachment hole 74 include nuts and bolts.

Further, as shown in FIG. 7B, the frame may be provided with a positioning pin, cutouts or the like for positioning peripheral components or the like. A shape of the frame is not particularly limited, and can be appropriately set depending on a shape of the object to be cooled, a shape of peripheral components provided around the object to be cooled and the cooling structure 70, and the like.

### <Eighth Embodiment>

FIG. 8 is a schematic perspective view of a cooling structure 80 of another embodiment in the present disclosure. In the cooling structure 80 shown in FIG. 8, a layered material 19 having resin layers on both sides of a thermally conductive layer made of metal is disposed inside the casing 12. The layered material 19 may be a laminated material in which the thermally conductive layer is laminated with the resin layers. Further, the thermally conductive material 18 described above may be used as the layered material 19.

A plurality of flow paths may be formed by the layered material 19. The layered material 19 may be processed into a crest and trough shape by corrugating, embossing or the like. The flow path may be divided into a plurality of sections by a crest and trough portion.

FIG. 8 shows an embodiment that both the wall material 16 and the layered material 19 are provided, and the refrigerant inlet 14 and the refrigerant outlet 15 are arranged on the same side of the casing 12. In a case in which the wall material 16 is provided, the arrangement positions of the refrigerant inlet 14 and the refrigerant outlet 15 can be freely designed.

Further, in a case in which the refrigerant inlet 14 and the refrigerant outlet 15 are arranged at one end and the other end of the casing 12, the layered material 19 may be provides without providing the wall material 16, or both the wall material 16 and the layered material 19 may be provided.

### <Ninth Embodiment>

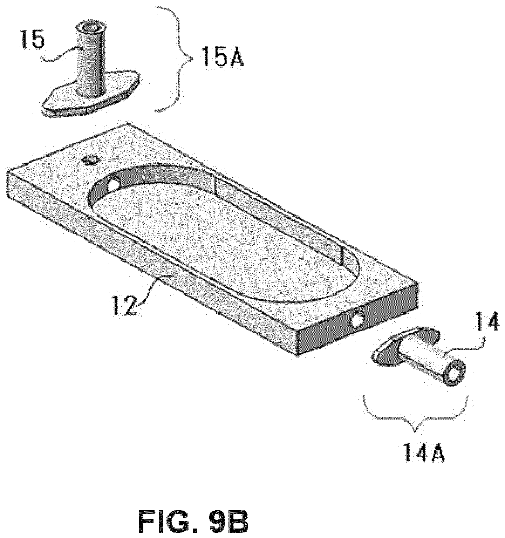

FIG. 9A is a schematic perspective view of a cooling structure 90 of another embodiment in the present disclosure, and FIG. 9B is an exploded view of FIG. 9A. In the cooling structure 90 shown in FIG. 9, the refrigerant inlet 14 and the refrigerant outlet 15 are configured separately from the casing 12, and a header part 14A having the refrigerant inlet 14 and a footer part 15A having the refrigerant outlet 15 are connected to the casing 12. In a case in which the refrigerant inlet 14 and the refrigerant outlet 15 are configured separately from the casing 12, a degree of freedom such as an arrangement position, an orientation, size, a shape or the like of the refrigerant inlet 14 and the refrigerant outlet 15 is increased compared to in a case in which they were integrally molded.

In the cooling structure 90 of FIG. 9, the coolant inlet 14 extends outward in a thickness direction of the cooling structure 90, and the coolant outlet 15 extends outward in the face direction of the cooling structure 90. The respective directions of the refrigerant inlet 14 and the refrigerant outlet 15 are not limited to those shown in FIG. 9.

Further, in the cooling structure 90 of FIG. 9, the refrigerant inlet 14 and the refrigerant outlet 15 are divided into a header part 14A and a footer part 15A, respectively, but the refrigerant inlet 14 and the refrigerant outlet 15 may be combined into a single component. For example, in FIGS. 1 and 2, the refrigerant inlet 14 and the refrigerant outlet 15 extend from the same side of the cooling structure, and therefore, a single component in which the refrigerant inlet 14 and the refrigerant outlet 15 are integrated may be provided as a separate member on the side.

### <Tenth Embodiment>

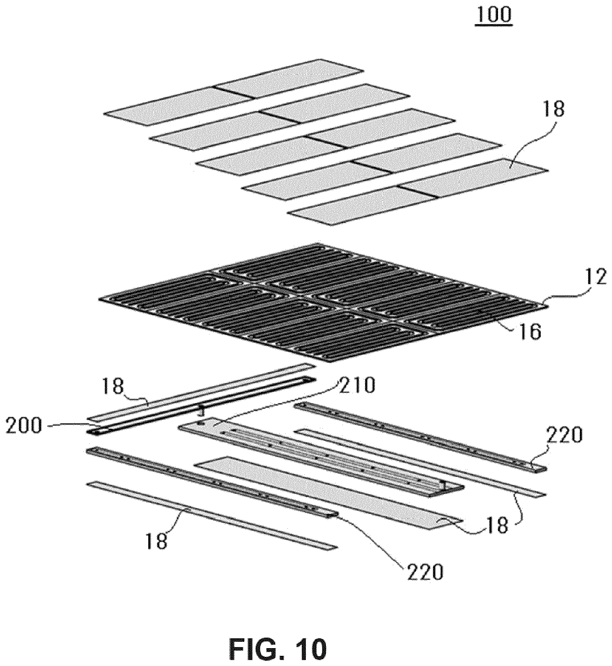

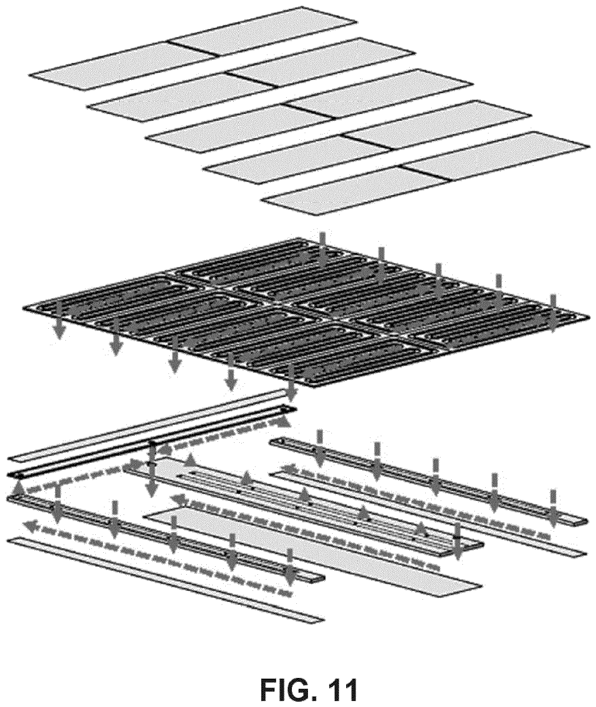

FIG. 10 is an exploded view schematically showing a cooling structure 100 of another embodiment in the present disclosure, and FIG. 11 is a diagram illustrating the flow of refrigerant in the cooling structure 100. The cooling structure 100 may include a plurality of casings 12, and may include a path for flowing a refrigerant to the plurality of casings 12. A material of the path is not particularly limited, and may be resin. The cooling structure 100 shown in FIG. 10 includes an inflow path 200, a branch path 210, and a collection path 220 as the path, but embodiments of the path is not limited to these.

As shown in FIG. 11, the refrigerant in the cooling structure 100 flows from the inflow path 200 to each casing 12 via the branch path 210 arranged in the center. The refrigerant that has passed through the casing 12 flows into the collection path 220 and is collected. The refrigerant may be circulated, in which case the refrigerant collected into the collection path 220 is returned to the inflow path 200. The refrigerant collected into the collection path 220 may be stored in a tank (not shown) or the like and then reused. Alternatively, the refrigerant that has passed through the casing 12 may be stored in a tank or the like without passing through the collection path 220. The refrigerant may be filtered to remove foreign substances before being reused.

In the cooling structure 100 shown in FIG. 10, the casings 12 are disposed on both sides of the branch path 210 located at the center, but the located position of the casings 12 is not limited to that shown in FIG. 10.

Further, in the cooling structure 100 shown in FIG. 10, the thermally conductive material 18 is disposed in each of the casing 12, the inflow path 200, the branching path 210, and the collection path 220, but a resin member may be provided instead of the thermally conductive material 18 as explained in the first embodiment.

### <Eleventh Embodiment>

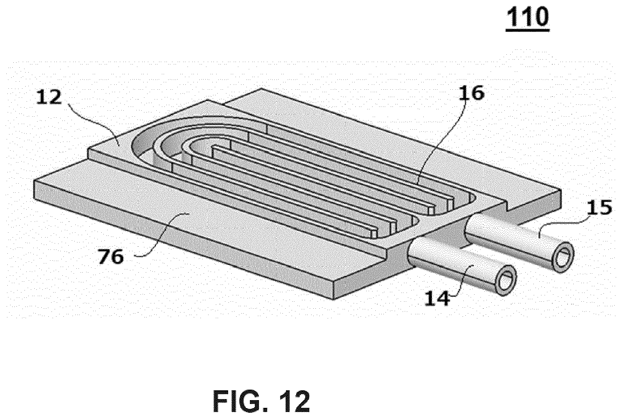

FIG. 12 is a schematic perspective view of a cooling structure 110 of another embodiment in the present disclosure. In the cooling structure 110 shown in FIG. 12, the casing 12 has a bottom face, and an extending portion 76 extending outward on the bottom face side.

The casing 12, the bottom face, and the extension portion 76 may be integrated, or may be integrally molded with resin. Furthermore, from the viewpoint of simplifying the assembly process and reducing the number of parts, the casing 12, the bottom face, the extension part 76, the refrigerant inlet 14, the refrigerant outlet 15, and the wall material 16 may be integrated.

A shape of the extending portion 76 is not particularly limited, and can be appropriately set depending on a shape of the object to be cooled, a shape of peripheral components provided around the object to be cooled and the cooling structure 70, and the like. For example, the extending portion 76 may be continuous from the bottom face so as to be flush without any step, or may have a step.

Further, in FIG. 12, the extension portion 76 extends in the face direction of the cooling structure 110, but it may extend in the thickness direction. The extending direction in the thickness direction may be on the bottom side or on the top side. Furthermore, the extending portion 76 may extend in the face direction and then bend in the thickness direction. The bending angle can also be set appropriately. It may have a curvature at the bending position. It may be bent not only once but also twice or more.

For example, in a configuration in which the extending portions 76 extending in the thickness direction are provided at both ends in the length direction or both ends in the width direction of the cooling structure 110, the object to be cooled may be held by the extending portions 76 at both ends. Such a configuration allows the cooling structure 110 to be installed stably or in close contact with the object to be cooled. Note that the extension portion 76 may be installed for purposes other than stability and close.

In FIG. 12, the extension portion 76 extends in the width direction of the cooling structure 110, but it may extend in the length direction. Furthermore, the extension portion 76 may extend in both the width direction and the length direction of the cooling structure 110 to be disposed around the casing 12.

Further, the extending portion 76 may partially extend to have an expanded portion (not shown), and an area of the extending portion 76 may be increased by the expanded portion. A shape of the expanded portion is not particularly limited.

A thickness and an area of the extension portion 76 can be designed as appropriate.

The present disclosures of Japanese Patent Application No. 2021-202702 is incorporated herein by reference in their entirety.

All documents, patent applications, and technical standards described in the present specification are incorporated herein by reference to the same extent as if each individual document, patent application, or technical standard were specifically and individually indicated to be incorporated by reference.

### Explanation of References

10, 20, 30, 40, 50, 60, 70, 80, 90, 100: Cooling structure, 12: Casing, 14: Refrigerant inlet, 15: Refrigerant outlet, 16: Wall material, 18: Thermally conductive material 19: Layered material, 72: Mounting member, 74: Bolt mounting hole, 76: Extension part, 200: Inflow waterway, 210: Branch waterway, 220: Collection waterway

## Claims

1. A cooling structure comprising a refrigerant inlet, a refrigerant outlet, and a flow path made of resin and connecting the refrigerant inlet and the refrigerant outlet, wherein a portion of a face configuring the flow path is open.

2. The cooling structure according to claim 1, comprising a plurality of flow paths, wherein the plurality of flow paths have respective open faces that open in a same direction.

3. The cooling structure according to claim 1 or 2, further comprising a member disposed at an area where the flow path is opened, the member and the cooling structure being entirely made of an identical resin material.

4. The cooling structure according to claim 1 or 2, further comprising a thermally conductive material disposed at an area where the flow path is opened

5. The cooling structure according to claim 4, wherein the thermally conductive material comprises a metal layer and a resin layer.

6. The cooling structure according to any one of claims 1 to 5, wherein the refrigerant inlet, the refrigerant outlet and the flow path are integrally molded with resin.

7. The cooling structure according to any one of claims 1 to 6, further comprising a mounting member.
